# EUROPEAN PATENT APPLICATION

(11) **EP 1 942 202 A2**
(43) Date of publication of application: **09.07.2008**
(21) Application number: 08100218.0
(22) Date of filing: 08.01.2008
(51) Int. Cl.: C22C 27/00, B22F 1/00, C22C 1/04, C23C 14/34

(54) **High density, low oxygen Re and Re-based consolidated powder materials for use as deposition sources & methods of making the same**

(30) Priority: 08.01.2007 US 879418 P; 13.04.2007 US 907633 P; 03.01.2008 US 969172
(71) Applicant: Heraeus, Inc., Chandler AZ 85226 (US)
(72) Inventor: Yang, Fenglin, Gilbert, AZ 85296 (US); Derrington, Carl, Tempe, AZ 85284 (US); Kunkel, Bernd, Phoenix, AZ 85048 (US)
(74) Representative: Hill, Justin John

(57) **Abstract**

A method of making Re and Re-based materials comprises steps of: providing a Re powder starting material or a Re powder starting material and at least one additional powder material; subjecting at least the Re powder to a first degassing treatment for reducing the oxygen content thereof; increasing the density of the degassed Re powder or a mixture of the degassed Re powder and the at least one additional powder material to form a green billet; subjecting the billet to a second degassing treatment to further reduce the oxygen content; and consolidating the billet to form a consolidated material with greater than about 95 % of theoretical density and low oxygen content below about 200 ppm for Re and below about 500 ppm for Re-based materials formed from the mixture, excluding oxygen from non-metallic compounds and ceramics. Materials so produced are useful in the manufacture of deposition sources such as sputtering targets.

## Description

### FIELD OF THE DISCLOSURE

The present disclosure relates generally to high density, low oxygen content Re and Re-based materials (such as alloys and metal-ceramics) and their method of manufacture. The present disclosure enjoys particular utility in the fabrication of deposition sources, e.g., sputtering targets, comprising Re and Re-based materials utilized in the deposition of thin film layers in the manufacture of data storage media, e.g., magnetic recording media.

### BACKGROUND OF THE DISCLOSURE

Ruthenium (Ru) is present only in limited amounts in nature and thus the demand for Ru and Ru-based materials, e.g., alloys, such as are commonly utilized in substantial volume in the manufacture of thin film data storage media, e.g., magnetic recording media, exceeds their supply.

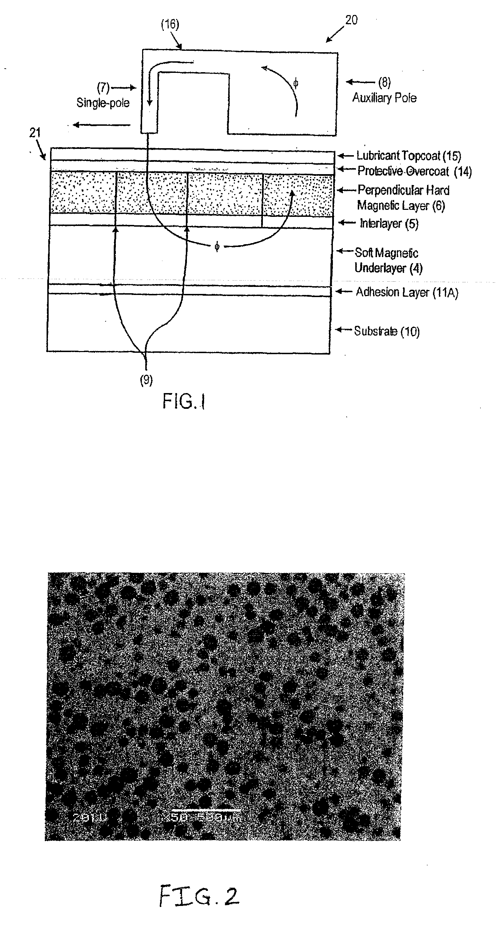

An example of a typical thin film perpendicular recording system **20** containing a Ru or Ru-based layer and comprising a vertically oriented magnetic recording medium **21** with a relatively thick soft magnetic underlayer, a relatively thin hard magnetic recording layer, and a single-pole head, is illustrated in FIG. 1, wherein reference numerals **10, 11A, 4, 5,** and **6** respectively indicate a non-magnetic substrate, an adhesion layer (optional), a soft magnetic underlayer, at least one non-magnetic interlayer, and at least one perpendicular hard magnetic recording layer. Reference numerals **7** and **8**, respectively, indicate the single and auxiliary poles of a single-pole magnetic transducer head **16**.

Briefly stated, the relatively thin interlayer **5** (also referred to as an "intermediate" layer and described in more detail below) underlying the at least one magnetically hard recording layer **6** is comprised of one or more layers of non-magnetic or substantially non-magnetic materials, typically Ru or a Ru-based alloy, and serves to (1) prevent magnetic interaction between the soft underlayer **4** and the at least one hard recording layer **6** and (2) promote desired microstructural and magnetic properties of the at least one magnetically hard recording layer **6**.

As shown by the arrows in FIG. 1 indicating the path of the magnetic flux φ, flux φ is seen as emanating from single pole **7** of single-pole magnetic transducer head **16**, entering and passing through the at least one vertically oriented, hard magnetic recording layer **6** in the region below single pole **7,** entering and traveling within soft magnetic underlayer **4** for a distance, and then exiting therefrom and passing through the at least one perpendicular hard magnetic recording layer **6** in the region below auxiliary pole **8** of single-pole magnetic transducer head **16**. The direction of movement of perpendicular magnetic medium **21** past transducer head **16** is indicated in the figure by the arrow above medium **21**.

With continued reference to FIG. 1, vertical lines **9** indicate grain boundaries of polycrystalline layers **5** and **6** of the layer stack constituting medium **21**. Magnetically hard main recording layer **6** is formed on interlayer 5, and while the grains of each polycrystalline layer may be of differing widths (as measured in a horizontal direction) represented by a grain size distribution, they are generally in vertical registry (i.e., vertically "correlated" or aligned).

Completing the layer stack is a protective overcoat layer **14**, such as of a diamond-like carbon (DLC), formed over hard magnetic layer **6**, and a lubricant topcoat layer **15**, such as of a perfluoropolyethylene material, formed over the protective overcoat layer.

Substrate **10** is typically disk-shaped and comprised of a non-magnetic metal or alloy, e.g., Al or an Al-based alloy, such as Al-Mg having an Ni-P plating layer on the deposition surface thereof, or substrate **10** is comprised of a suitable glass, ceramic, glass-ceramic, polymeric material, or a composite or laminate of these materials. Optional adhesion layer **11A,** if present, may comprise an up to about 40 Å thick layer of a material such as Ti or a Ti alloy. Soft magnetic underlayer **4** is typically comprised of an about 500 to about 4,000 Å thick layer of a soft magnetic material selected from the group consisting of Ni, NiFe (Permalloy), Co, CoZr, CoZrCr, CoZrNb, CoFeZrNb, CoFe, Fe, FeN, FeSiAl, FeSiAlN, FeCoB, FeCoC, etc.

Interlayer **5** located beneath the magnetically hard recording layer **6** plays a critical role (see below) in the formation of certain types of media, e.g., granular perpendicular magnetic recording media exhibiting optimum recording and stability performance, and typically comprises an up to about 300 Å thick layer or layers of non-magnetic material(s), such as Ru, TiCr, Ru/CoCr₃₇Pt₆, RuCr/CoCrPt, etc.

The at least one magnetically hard recording layer **6** has perpendicular magnetic anisotropy, is typically comprised of an about 100 to about 250 Å thick layer(s) of Co-based alloy(s) including one or more elements selected from the group consisting of Cr, Fe, Ta, Ni, Mo, Pt, V, Nb, Ge, B, and Pd, iron nitrides or oxides, and is generally formed (e.g., as by sputter deposition) on a non-magnetic (or at most weakly magnetic), crystalline interlayer **5**, typically a hcp-structured layer which enhances the Co <0002> crystalline texture of the overlying Co-based granular magnetic recording layer **6** perpendicular to the to the film plane, thereby resulting in very high perpendicular anisotropy. As a consequence, interlayer **5** is essential in the formation of granular perpendicular magnetic recording media exhibiting optimum recording and stability performance.

Notwithstanding the critical role played by the Ru and/or Ru-based alloy interlayer **5** in the manufacture of high performance data storage applications, e.g., granular perpendicular magnetic recording media such as described above, the constantly increasing demand for Ru and its alloys exceeds the Ru supply capacity and therefore necessitates development of other, more abundant and thus less costly non-magnetic materials useful in the formation of interlayers of magnetic recording media. In particular, rhenium (Re) and Re-based materials, e.g., Re-based alloys, have attracted attention as potential replacements for Ru and its alloys for use as thin film deposition sources, e.g., sputtering targets.

In view of the foregoing, there exists a clear need for cost-effective methodology for manufacturing high density, low oxygen content Re and Re-based materials (such as Ru-based alloys) suitable for use as deposition sources, e.g., sputtering targets, utilized in fabricating high areal recording density, high performance magnetic recording media with improved stability and optimal magnetic properties.

### SUMMARY OF THE DISCLOSURE

An advantage of the present disclosure is improved methodology for forming high density, low oxygen content consolidated powder materials comprising Re and Re-containing materials.

A further advantage of the present disclosure is improved methodology for forming deposition sources, e.g., sputtering targets, comprising high density, low oxygen content consolidated powder materials comprising Re and Re-containing materials.

Another advantage of the present disclosure is improved, high density, low oxygen content consolidated powder materials comprising Re and Re-containing materials.

Yet another advantage of the present disclosure is improved deposition sources, e.g., sputtering targets, comprising high density, low oxygen content consolidated powder materials comprising Re and Re-containing materials.

Additional advantages and other features of the present disclosure will be set forth in the description which follows and in part will become apparent to those having ordinary skill in the art upon examination of the following or may be learned from the practice of the present disclosure. The advantages of the present disclosure may be realized and obtained as particularly pointed out in the appended claims.

According to an aspect of the present disclosure, the foregoing and other advantages are obtained in part by an improved method comprising steps of:
(a) providing a Re powder starting material or a Re powder starting material and at least one additional powder material;
(b) subjecting at least the Re powder to a first degassing treatment for reducing the oxygen content thereof;
(c) increasing the density of the degassed Re powder or a mixture of the degassed Re powder and the at least one additional powder material to form a green billet;
(d) subjecting the green billet to a second degassing treatment to further reduce the oxygen content thereof; and
(e) consolidating the green billet to form a consolidated material with greater than about 95 % of theoretical density and low oxygen content below about 200 ppm for Re and below about 500 ppm for Re-based materials formed from the mixture, excluding oxygen from non-metallic compounds and/or ceramics.

Preferably, step (e) comprises consolidating the green billet and forming a consolidated material with greater than about 99 % of theoretical density and low oxygen content below about 100 ppm for Re and below about 200 ppm for Re-based materials formed from the mixture, excluding oxygen from non-metallic compounds and/or ceramics.

According to embodiments of the present disclosure, the method further comprises a step of:
(f) forming at least one deposition source from the consolidated material; e.g., forming at least one sputtering target.

In accordance with embodiments of the present disclosure, step (c) comprises forming a billet comprising the degassed Re powder or the mixture, as by cold isostatic pressing (CIP) or cold mechanical pressing; and step (d) comprises maintaining the billet at an elevated temperature while contacting the billet with H₂ gas.

According to certain embodiments of the present disclosure, step (e) comprises steps of: (e₁) encapsulating the billet in a container; and (e₂) subjecting the encapsulated billet to hot isostatic pressing (HIP) to form the consolidated material; whereas according to other embodiments of the present disclosure, step (e) comprises steps of: (e₁) subjecting the billet to vacuum hot pressing (VHP) or spark plasma sintering (SPS) to achieve < - 97 % of theoretical density; and (e₂) subjecting the thus-treated billet to hot isostatic pressing (HIP) to form the consolidated material with > ~ 97 % of theoretical density.

According to certain embodiments of the present disclosure, step (a) comprises providing a Re powder starting material; and step (e) comprises forming a consolidated Re material having 100 % of theoretical density and oxygen content below about 100 ppm; whereas, according to other embodiments of the present disclosure, step (a) comprises providing a Re powder starting material and a predetermined amount of at least one additional powder material comprising at least one transition metal element X; and step (e) comprises forming a consolidated material of formula Re-X, comprising predetermined proportions of Re and the at least one transition metal. For example, step (a) comprises providing a predetermined amount at least one additional powder material comprising at least one transition metal selected from the group consisting of Mo, Co, Ru, W, and Cr; and step (e) comprises forming a consolidated Re-X material having greater than about 99.0 % of theoretical density, oxygen content below about 200 ppm, a Re phase, an X phase, and a Re-X phase.

In accordance with still other embodiments of the present disclosure, step (a) comprises providing a Re powder starting material and a predetermined amount of at least one additional powder material comprising at least one material Y selected from the group consisting of non-metallic elements, non-metallic compounds, and ceramic materials; and step (e) comprises forming a consolidated material of formula Re-Y, comprising predetermined proportions of Re and the at least one non-metallic element, non-metallic compound, or ceramic material. For example, Y is at least one carbide or nitride or an oxide of Ti, Si, or Mg.

According to still another embodiment of the present disclosure, step (a) comprises providing a predetermined amount of Re powder starting material, a predetermined amount of at least one additional powder material comprising at least one transition metal element X, and a predetermined amount of at least one additional powder material comprising at least one material Y selected from the group consisting of non-metallic elements, non-metallic compounds, and ceramic materials; and step (e) comprises forming a consolidated material of formula Re-X-Y, comprising predetermined proportions of Re, the at least one transition metal element X, and the at least one non-metallic element, non-metallic compound, or ceramic material Y. For example, X is at least one transition metal selected from the group consisting of Mo, Co, Ru, W, and Cr, and Y is at least one carbide or nitride or an oxide of Ti, Si, or Mg.

Embodiments of the present disclosure include those wherein steps (c) - (e) are replaced by a single step process, e.g., a process selected from the group consisting of: vacuum hot pressing (VHP), spark plasma sintering (SPS), microwave sintering, atmospheric pressure H₂ sintering, and vacuum H₂ sintering.

Another aspect of the present disclosure is an improved deposition source comprising consolidated Re powder material having greater than about 95 % of theoretical density and oxygen content below about 200 ppm, preferably greater than about 99 % of theoretical density and oxygen content below about 100 ppm, more preferably 100 % of theoretical density.

A further aspect of the present disclosure is an improved deposition source comprising consolidated Re-X powder material, where X is at least one transition metal element, the consolidated Re-X powder material having greater than about 95 % of theoretical density, oxygen content below about 500 ppm, a Re phase, an X phase, and a Re-X phase. Preferably, the consolidated Re-X powder material has greater than about 99 % of theoretical density and oxygen content below about 200 ppm. Transition metal element X is preferably selected from the group consisting of Mo, Co, Ru, W, and Cr.

Still another aspect of the present disclosure is an improved deposition source comprising consolidated Re-Y powder material, where Y is at least one non-metallic element, non-metallic compound, or ceramic material, the consolidated Re-Y powder material having greater than about 95 % of theoretical density and oxygen content below about 500 ppm, excluding oxygen from non-metallic compounds and/or ceramics, preferably greater than about 99 % of theoretical density and oxygen content below about 200 ppm, excluding oxygen from non-metallic compounds and/or ceramics. Y is preferably at least one carbide or nitride or oxide ofTi, Si, and Mg.

Yet another aspect of the present disclosure is an improved deposition source comprising consolidated Re-X-Y powder material, where X is at least one transition metal element and Y is at least one non-metallic element, non-metallic compound, or ceramic material, the consolidated Re-X-Y powder material having greater than about 95 % of theoretical density and oxygen content below about 500 ppm, excluding oxygen from non-metallic compounds and/or ceramics, preferably greater than about 99 % of theoretical density and oxygen content below about 200 ppm, excluding oxygen from non-metallic compounds and/or ceramics. Preferably, the at least one transition metal element X is selected from the group consisting of Mo, Co, Ru, W, and Cr; and Y is at least one carbide or nitride or an oxide of Ti, Si, or Mg.

Additional advantages and aspects of the disclosure will become readily apparent to those skilled in the art from the following detailed description, wherein embodiments of the present methodology are shown and described, simply by way of illustration of the best mode contemplated for practicing the present disclosure. As will be described, the present disclosure is capable of other and different embodiments, and its several details are susceptible of modification in various obvious respects, all without departing from the spirit of the present disclosure. Accordingly, the drawing and description are to be regarded as illustrative in nature, and not as limitative.

### BRIEF DESCRIPTION OF THE DRAWINGS

The following detailed description of the embodiments of the present disclosure can best be understood when read in conjunction with the following drawing, in which the various features (e.g., layers) are not necessarily drawn to scale but rather are drawn as to best illustrate the pertinent features, wherein:

FIG. 1 schematically illustrates, in simplified cross-sectional view, a portion of a magnetic recording storage, and retrieval system comprised of a perpendicular magnetic recording medium and a single pole transducer head;

FIGS. 2 and 3 are micrographs showing the microstructure of a sputtering target comprising Re - 50 at. % Co consolidated powder material formed according to an embodiment of the present disclosure;

FIG. 4 is a micrograph showing the microstructure of a sputtering target comprising Re - 15 at. % Mo consolidated powder material formed according to another embodiment of the present disclosure;

FIG. 5 is a micrograph showing the microstructure of a sputtering target comprising Re - 20 at. % W consolidated powder material formed according to yet another embodiment of the present disclosure;

FIG. 6 is a micrograph showing the microstructure of a sputtering target comprising Re - 25 at. % Cr consolidated powder material formed according to still another embodiment of the present disclosure; and

FIG. 7 is a micrograph showing the microstructure of a sputtering target comprising Re - 50 at. % Ru consolidated powder material formed according to a further embodiment of the present disclosure.

### DETAILED DESCRIPTION OF THE DISCLOSURE

The present disclosure has as an aim provision of improved Re and Re-based materials for use, *inter alia,* as thin film layers in the manufacture of stable, high performance, high areal recording density magnetic recording media, e.g., granular perpendicular magnetic recording media. A key requirement for obtaining such high performance media is formation of magnetically hard granular perpendicular recording layers with well-isolated, fine grain structure coupled with large perpendicular magnetic anisotropy Kᵤ.

As indicated *supra,* in such media, the granular perpendicular magnetic recording layer is usually deposited on a non-magnetic or weakly magnetic, crystalline *hcp*-based interlayer, typically a Ru or Ru-based alloy layer, which enhances the Co <0002> texture of the Co-based magnetically hard recording layer perpendicular to the film plane, thus leading to high perpendicular magnetic anisotropy Kᵤ.

The present disclosure is based upon recognition that Re and Re-based layers, in view of the relative abundance of Re vis-à-vis Ru, the *hcp* crystal structure of Re and Re-based materials at room temperature, and relative inertness leading to resistance to oxide formation at its interface with oxygen-containing granular perpendicular magnetic alloy layers, make them excellent, economically viable candidates for replacement of Ru and Ru-based alloy materials as interlayers in the formation of magnetic recording media, particularly granular perpendicular media.

In this regard, it is important to note that the interlayer of granular perpendicular magnetic recording media functions not only to enhance the crystallographic texturing of the overlying granular magnetic recording layer, but can also contribute to its grain size refinement when the latter is epitaxially grown on an interlayer with refined grain sizes. Further, close lattice matching between the interlayer and the overlying granular recording layer ensures formation of a substantially defect-free interface therebetween, reducing likelihood of in-plane magnetization.

Briefly stated, according to key features of the present disclosure, the Re and Re-based materials possess:
-- high densities, i.e., greater than about 95 % of theoretical density, preferably greater than about 99 % of theoretical density; and
-- low oxygen content, i.e., lower than about 200 ppm for pure Re and lower than about 500 ppm for Re-based materials (excluding oxygen from non-metallic compounds and/or ceramics), preferably lower than about 100 ppm for pure Re and lower than about 200 ppm for Re-based materials (excluding oxygen from non-metallic compounds and/or ceramics).

Re and Re-based materials contemplated by the present disclosure include:
-- pure Re, i.e., 100 % Re;
-- Re-X, where X is at least one transition metal element, e.g., Mo, Co, Ru, W, Cr;
-- Re-Y, where Y is at least one non-metallic element, compound, or ceramic material, e.g., oxides of Ti, Si, and Mg, and carbides and nitrides; and
-- Re-X-Y, where X and Y are as defined above.

Manufacture of high density, low oxygen content Re and Re-based materials poses a number of significant challenges, including:
-- the high melting point of Re (3180 °C) makes sintering difficult;
-- typically available Re powders (made via a chemical reduction process) have very low packing densities, i.e., on the order of about 14 % of theoretical, leading to high shrinkage rates during consolidation processing resulting in cracking and unpredictable deformation;
-- Re powders, which typically possess high surface area, tend to pick up oxygen even under ambient conditions; as a consequence it is difficult to maintain low oxygen levels in Re powders during normal handling; and
-- low oxygen contents, such as specified above, are required for deposition sources, e.g., sputtering targets, to perform well.

Briefly stated, key steps according to the instant methodology for forming high density, low oxygen content Re and Re-based materials for use as deposition sources (e.g., sputtering targets) include:
1. reducing the oxygen content of the raw Re or Re-based powder starting material to form a degassed green material with a lowered oxygen level;
2. consolidating the green material to form a consolidated material with greater than about 95 % of theoretical density, preferably greater than about 99 % of theoretical density, and with low oxygen content, i.e., lower than about 200 ppm for pure Re and lower than about 500 ppm for Re-based materials (excluding oxygen from non-metallic compounds and/or ceramics), preferably lower than about 100 ppm for pure Re and lower than about 200 ppm for Re-based materials (excluding oxygen from non-metallic compounds and/or ceramics); and
3. forming at least one deposition source (e.g., sputtering target) from the consolidated material.

According to certain embodiments of the present disclosure, step 2 for consolidating the green material comprises performing a plurality of steps, including in sequence:
2A. increasing the density of the degassed green material, e.g., by cold isostatic pressing (CIP) or cold mechanical pressing;
2B. further degassing the increased density green material by treatment with hydrogen (H₂) gas to reduce/remove any surface oxygen and further reduce oxygen content of the powder particles of the green material; and
2C. consolidating the further degassed green material.

According to a first alternative procedure for consolidating the further degassed material in step 2C, a billet of degassed green material is encapsulated in a container and then subjected to hot isostatic pressing (HIP); whereas, according to a second alternative procedure for consolidating the further degassed material, a billet of degassed green material is subjected to vacuum hot pressing (VHP) or spark plasma sintering (SPS) to achieve < ~ 97 % of theoretical density and then the thus-treated billet is subjected to hot isostatic pressing (HIP) to form the consolidated material with > ~ 97 % of theoretical density.

According to other embodiments of the present disclosure, however, step 2 for consolidation of the degassed green material is performed by an alternative method, such that steps 2A - 2C are replaced with a single step performed, e.g., by vacuum hot pressing (VHP), spark plasma sintering (SPS), microwave sintering, atmospheric pressure H₂ sintering, or vacuum H₂ sintering.

In more detail, according to the present disclosure, the particle size distribution (PSD) of the raw powder provided in step 1 is typically -200 mesh, although smaller and larger mesh powders such as -100 mesh and -325 mesh may also be utilized. The tap density and bulk density of raw Re powder obtained via chemical reduction processing (e.g., from ammonium perrhenate, NH₄ReO₄) are 2.86 gm/cm³ and 1.63 gm/cm³, respectively, and the oxygen content is typically > ~ 1000 ppm, which must be reduced to < ~ 1000 ppm, e.g., as low as about 100 ppm (depending upon the specification of the resultant deposition source, e.g., a sputtering target). This may be accomplished by degassing treatment in a H₂ furnace or a vacuum furnace containing H₂. Control of the powder degas temperature and interval is required for obtaining the requisite reduced oxygen content, without causing premature sintering of the powder and forming closed pores within the powder particles.

The powders of any metal of non-metal additive constituents (X and/or Y) to be added to the raw Re powder should have a PSD similar to that of the raw Re powder. However, the PSD of the powder(s) of the X and/or Y additive constituents may be larger or smaller than that of the raw Re powder, depending upon the desired composition of the ultimate Re-based material, as well as upon other properties such as density, particle shape, etc. The powders of the X and/or Y additive constituents should also have a low oxygen content, typically < 500 ppm, but which can be lower or higher depending upon the requisite oxygen content of the resultant target, the powder properties, and its proportion (e.g., at. %) in the resultant target.

The raw Re powder and the powder(s) of the X and/or Y additive constituents are weighed out in predetermined amounts (for achieving products having desired constituent proportions) and then blended together, as in a tumbling blender, for a sufficient interval for obtaining good mixing, i.e., typically within 15 - 60 min., although shorter or longer blending times are possible as necessary.

Densification of the degassed pure Re powder or blended Re (X and/or Y) powders according to step 2A to form an increased density degassed green powder material may, for example, be accomplished by cold isostatic pressing (CIP) or mechanical pressing, e.g., as by loading the degassed powder or blended powder into a CIP bag or die under an inert atmosphere and performing CIP or mechanical pressing at a pressure between about 20 and about 60 ksi to achieve a green density > ~ 50 %.

As for step 2B, when the resultant deposition source is required to have an ultra-low oxygen content, the billet formed by CIP or cold mechanical pressing in step 2A requires further degassing treatment, as in a H₂ furnace or vacuum oven, to reduce/remove any oxygen on the powder surfaces picked up during previous powder handling, and to further reduce the oxygen content within the powder particles. Control of the degassing temperatures and intervals (which will vary according to the composition of the pressed billet) to optimum values is necessary in order to reduce/remove the oxygen without causing premature sintering and closing off of pores of the powder (as at excessively high temperatures) or obtaining insufficient oxygen removal (as at too low temperatures). In general, pre-sintering density of the billet should not exceed about 92 %. Examples of suitable temperatures for performing H₂ degassing treatment are: 850 °C for Re-Co; 950 °C for Re-Ru, and 1050 °C for pure Re, Re-Mo, and Re-W.

Step 2B may be skipped when the oxygen content of the resultant Re or Re-based deposition source (e.g., sputtering target) is not too low, or when the oxygen content of the raw or degassed green powder is sufficiently low.

Step 2C comprises loading the billet into a suitable metal or metal alloy can, e.g., a low carbon steel (LCS) can coated with alumina (Al₂O₃) or a Ti can (with or without a coating), heating the can, evacuating the can to achieve a vacuum, and sealing the can. Hot isostatic pressing (HIP) is then performed to consolidate the billet. The temperature utilized for HIP is generally above about 1000 °C but will depend upon the composition of the billet; the pressure will range from about 15 to about 45 ksi, and the HIP interval generally is in the range of several hours, e.g., 4 - 10 hrs.

Step 3 comprises sectioning the consolidated HIP billet by any suitable method, e.g., electrical discharge machining (EDM), into slices of desired thickness, followed by machining to final deposition source (e.g., sputtering target) dimensions.

The utility and versatility of the present disclosure will now be demonstrated with reference to the following illustrative, but non-limitative examples.

### Example 1

A Re - 50 at. % Co sputtering target was fabricated according to the following procedure:

A -325 mesh reduced Re powder with as-supplied oxygen content of about 2200 ppm was degassed at a peak temperature of 1050 °C under a H₂ atmosphere in a vacuum furnace to reduce the oxygen content to < ~ 120 ppm.

The degassed Re powder was then blended with an appropriate amount of -100 mesh Co powder for about 45 min. in a tumbler-type blender, and the blended powder subjected to CIP at about 55 ksi. The resulting CIP billet was degassed in a H₂ atmosphere at a peak temperature of about 850 °C, followed by encapsulation in a can and evacuation and sealing of the can. The encapsulated CIP billet was then subjected to HIP at a peak temperature of 1236 °C and 29 ksi pressure, and final targets of desired dimensions were machined from the consolidated HIP billet.

The density of the resultant sputtering target material was 100 % of theoretical, oxygen content was 66 ppm, and micrographic examination (see FIGS. 2 - 3) revealed the presence of three (3) distinct phases in the resultant Re-Co alloy, namely: a pure Re phase, a pure Co phase, and a minor amount of a Re-Co phase.

### Example 2

A Re - 15 at. % Mo sputtering target was fabricated according to the following procedure:

A -325 mesh reduced Re powder with as-supplied oxygen content of about 2200 ppm was degassed at a peak temperature of 1050 °C under a H₂ atmosphere in a vacuum furnace to reduce the oxygen content to < ~ 120 ppm.

The degassed Re powder was then blended with an appropriate amount of -325 mesh Mo powder for about 45 min. in a tumbler-type blender, and the blended powder subjected to CIP at about 55 ksi. The resulting CIP billet was degassed in a H₂ atmosphere at a peak temperature of about 1050 °C, followed by encapsulation in a can and evacuation and sealing of the can. The encapsulated CIP billet was then subjected to HIP at a peak temperature of 1515 °C and 29 ksi pressure, and final targets of desired dimensions were machined from the consolidated HIP billet.

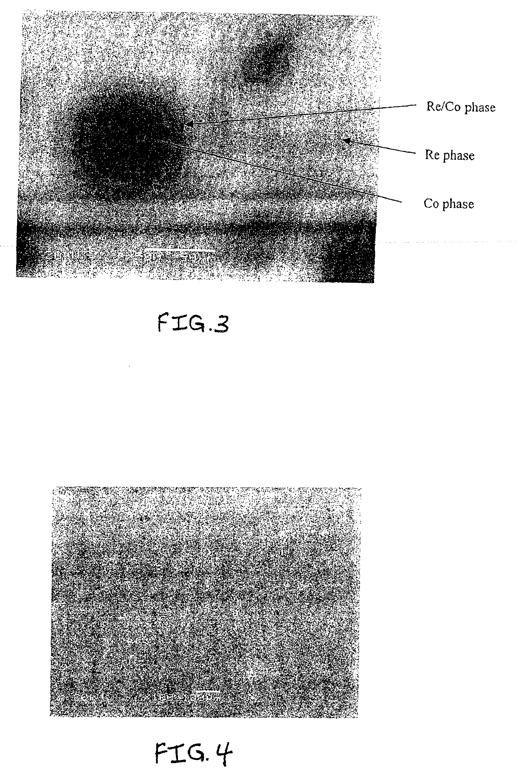

The density of the resultant sputtering target material was 99.3 % of theoretical, oxygen content was 108 ppm, and micrographic examination (see FIG. 4) revealed the presence of distinct Re and Mo phases, the Re phases corresponding to the lighter areas in FIG. 4.

### Example 3

A pure (i.e., 100 %) Re sputtering target was fabricated according to the following procedure:

A -200 mesh reduced Re powder was degassed at a peak temperature of 1050 °C under a H₂ atmosphere in a vacuum furnace to reduce the oxygen content to < ~ 120 ppm.

The degassed Re powder was then homogenized for about 10 min. in a tumbler-type blender, and the homogenized powder subjected to CIP at about 55 ksi. The resulting CIP billet was degassed in a H₂ atmosphere at a peak temperature of about 1050 °C, followed by encapsulation in a can and evacuation and sealing of the can. The encapsulated CIP billet was then subjected to HIP at a peak temperature of 1515 °C and 29 ksi pressure, and final targets of desired dimensions were machined from the consolidated HIP billet.

The density of the resultant pure Re sputtering target material was 100 % of theoretical, and the oxygen content was 47 ppm.

### Example 4

A Re - 20 at. % W sputtering target was fabricated according to the following procedure:

A -200 mesh reduced Re powder was degassed at a peak temperature of 1050 °C under a H₂ atmosphere in a vacuum furnace to reduce the oxygen content to < ~ 120 ppm.

The degassed Re powder was then blended with an appropriate amount of -325 mesh W powder for about 45 min. in a tumbler-type blender, and the blended powder subjected to CIP at about 55 ksi. The resulting CIP billet was degassed in a H₂ atmosphere at a peak temperature of about 1050 °C, followed by encapsulation in a can and evacuation and sealing of the can. The encapsulated CIP billet was then subjected to HIP at a peak temperature of 1515 °C and 29 ksi pressure, and final targets of desired dimensions were machined from the consolidated HIP billet.

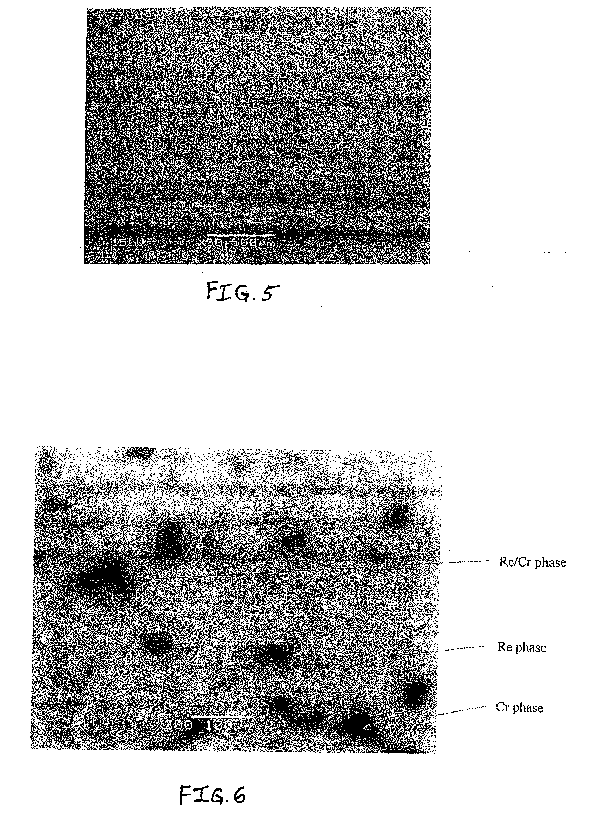

The density of the resultant sputtering target material was 99.5 % of theoretical, oxygen content was 65 ppm, and micrographic examination (see FIG. 5) revealed the presence of distinct Re and W phases, the Re phases corresponding to the lighter areas in FIG. 5.

### Example 5

A Re - 25 at. % Cr sputtering target was fabricated according to the following procedure:

A -200 mesh reduced Re powder was degassed at a peak temperature of 1050 °C under a H₂ atmosphere in a vacuum furnace to reduce the oxygen content to < ~ 120 ppm.

The degassed Re powder was then blended with an appropriate amount of -325 mesh Cr powder for about 45 min. in a tumbler-type blender, and the blended powder subjected to CIP at about 55 ksi. The resulting CIP billet was degassed in a H₂ atmosphere at an elevated temperature, followed by encapsulation in a can and evacuation and sealing of the can. The encapsulated CIP billet was then subjected to HIP at a peak temperature of 1450 °C and 29 ksi pressure, and final targets of desired dimensions were machined from the consolidated HIP billet.

The density of the resultant sputtering target material was 99.2 % of theoretical, oxygen content was 162 ppm, and micrographic examination (see FIG. 6) revealed the presence of three (3) distinct phases, i.e., a pure Re phase, a pure Cr phase, and a Re-Cr phase.

### Example 6

A Re - 50 at. % Ru sputtering target was fabricated according to the following procedure:

A -200 mesh reduced Re powder was degassed at a peak temperature of 1050 °C under a H₂ atmosphere in a vacuum furnace to reduce the oxygen content to < ~ 120 ppm.

The degassed Re powder was then blended with an appropriate amount of -325 mesh Ru powder (degassed to oxygen content < ~ 200 ppm) for about 45 min. in a tumbler-type blender, and the blended powder subjected to CIP at about 55 ksi. The resulting CIP billet was degassed in a H₂ atmosphere at a peak temperature of about 950 °C, followed by encapsulation in a can and evacuation and sealing of the can. The encapsulated CIP billet was then subjected to HIP at a peak temperature of 1515 °C and 29 ksi pressure, and final targets of desired dimensions were machined from the consolidated HIP billet.

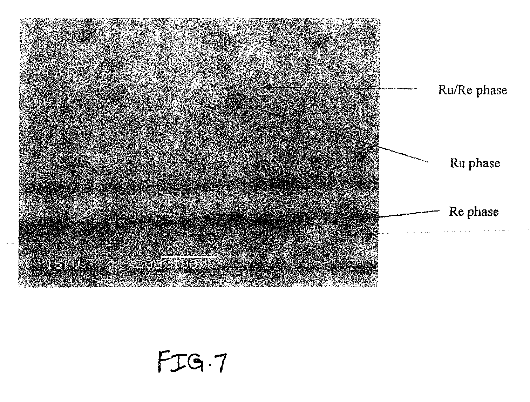

The density of the resultant sputtering target material was 100 % of theoretical, oxygen content was 102 ppm, and micrographic examination (see FIG. 7) revealed the presence of three (3) distinct phases, i.e., a pure Re phase, a pure Ru phase, and a Re-Ru phase.

In summary, the present disclosure provides improved methodology for forming high density, low oxygen content Re and Re-based materials and deposition sources comprising same, e.g., sputtering targets, which Re and Re-based alloy targets are particularly useful in the formation of crystalline interlayers in layer stacks of thin film, Co-based granular perpendicular magnetic recording media. The enhanced magnetic recording layers afforded by the present disclosure facilitate manufacture of high performance, high areal recording density granular perpendicular magnetic recording media with improved signal-to-noise ratio (SNR) and increased perpendicular magnetic anisotropy.

In the previous description, numerous specific details are set forth, such as specific materials, structures, processes, etc., in order to facilitate a better understanding of the present disclosure. However, the present disclosure can be practiced without resorting to the details specifically set forth herein. In other instances, well-known processing techniques, instrumentalities, and structures have not been described in order not to unnecessarily obscure the present disclosure.

Only the preferred embodiments of the present disclosure and but a few examples of its versatility are shown and described herein. It is to be understood that the present disclosure is capable of use in other combinations and environments and is susceptible of changes and/or modifications within the scope of the disclosed concept as expressed herein.

## Claims

1. A method comprising steps of:
(a) providing a Re powder starting material or a Re powder starting material and at least one additional powder material;
(b) subjecting at least said Re powder to a first degassing treatment for reducing the oxygen content thereof;
(c) increasing the density of said degassed Re powder or a mixture of said degassed Re powder and said at least one additional powder material to form a green billet;
(d) subjecting said green billet to a second degassing treatment to further reduce the oxygen content thereof; and
(e) consolidating said green billet to form a consolidated material with greater than about 95 % of theoretical density and low oxygen content below about 200 ppm for Re and below about 500 ppm for Re-based materials formed from said mixture, excluding oxygen from non-metallic compounds and/or ceramics.

2. The method according to claim 1, wherein:
step (e) comprises consolidating said green billet and forming a consolidated material with greater than about 99 % of theoretical density and low oxygen content below about 100 ppm for Re and below about 200 ppm for Re-based materials formed from said mixture, excluding oxygen from non-metallic compounds and/or ceramics.

3. The method according to claim 1, further comprising a step of:
(f) forming at least one deposition source from said consolidated material.

4. The method according to claim 3, wherein:
step (f) comprises forming at least one sputtering target.

5. The method according to claim 1, wherein:
step (c) comprises forming said green billet by cold isostatic pressing (CIP) or mechanical pressing; and
step (d) comprises maintaining said billet at an elevated temperature while contacting said billet with H₂ gas.

6. The method according to claim 1, wherein step (e) comprises steps of:
(e₁) encapsulating said billet of degassed green material in a container; and
(e₂) subjecting said encapsulated billet to hot isostatic pressing (HIP) to form said consolidated material.

7. The method according to claim 1, wherein step (e) comprises steps of
(e₁) subjecting said billet of degassed green material to vacuum hot pressing (VHP) or spark plasma sintering (SPS) to achieve < ~ 97 % of theoretical density; and
(e₂) subjecting the thus-treated billet to hot isostatic pressing (HIP) to form said consolidated material with > ~ 97 % of theoretical density.

8. The method according to claim 1, wherein:
step (a) comprises providing a Re powder starting material; and
step (e) comprises forming a consolidated Re material having 100 % of theoretical density and oxygen content below about 100 ppm.

9. The method according to claim 1, wherein:
step (a) comprises providing a Re powder starting material and a predetermined amount of at least one additional powder material comprising at least one transition metal element X; and
step (e) comprises forming a consolidated material of formula Re-X, comprising predetermined proportions of Re and said at least one transition metal.

10. The method according to claim 9, wherein:
step (a) comprises providing a predetermined amount at least one additional powder material comprising at least one transition metal selected from the group consisting of Mo, Co, Ru, W, and Cr; and
step (e) comprises forming a consolidated Re-X material having greater than about 99.0 % of theoretical density, oxygen content below about 200 ppm, a Re phase, an X phase, and a Re-X phase.

11. The method according to claim 1, wherein:
step (a) comprises providing a Re powder starting material and a predetermined amount of at least one additional powder material comprising at least one material Y selected from the group consisting of non-metallic elements, non-metallic compounds, and ceramic materials; and
step (e) comprises forming a consolidated material of formula Re-Y, comprising predetermined proportions of Re and said at least one non-metallic element, non-metallic compound, or ceramic material.

12. The method according to claim 11, wherein:
Y is at least one carbide or nitride or an oxide of Ti, Si, or Mg.

13. The method according to claim 1, wherein:
step (a) comprises providing a predetermined amount of Re powder starting material, a predetermined amount of at least one additional powder material comprising at least one transition metal element X, and a predetermined amount of at least one additional powder material comprising at least one material Y selected from the group consisting of non-metallic elements, non-metallic compounds, and ceramic materials; and
step (e) comprises forming a consolidated material of formula Re-X-Y, comprising predetermined proportions of Re, said at least one transition metal element X, and said at least one non-metallic element, non-metallic compound, or ceramic material Y.

14. The method according to claim 13, wherein:
X is at least one transition metal selected from the group consisting of Mo, Co, Ru, W, and Cr; and Y is at least one carbide or nitride or an oxide of Ti, Si, or Mg.

15. The method according to claim 1, wherein:
steps (c) - (e) are replaced by a single step process.

16. The method according to claim 15, wherein steps (c) - (e) are replaced by a process selected from the group consisting of: vacuum hot pressing (VHP), spark plasma sintering (SPS), microwave sintering, atmospheric pressure H₂ sintering, and vacuum H₂ sintering.

17. A deposition source comprising consolidated Re powder material having greater than about 95 % of theoretical density and oxygen content below about 200 ppm.

18. The deposition source as in claim 17, wherein said consolidated Re powder material has greater than about 99 % of theoretical density and oxygen content below about 100 ppm.

19. The deposition source as in claim 18, wherein said consolidated Re powder material has 100 % of theoretical density.

20. A deposition source comprising consolidated Re-X powder material, where X is at least one transition metal element, said consolidated Re-X powder material having greater than about 95 % of theoretical density, oxygen content below about 500 ppm, a Re phase, an X phase, and a Re-X phase.

21. The deposition source as in claim 20, wherein said consolidated Re-X powder material has greater than about 99 % of theoretical density and oxygen content below about 200 ppm.

22. The deposition source as in claim 20, wherein said at least one transition metal element X is selected from the group consisting of Mo, Co, Ru, W, and Cr.

23. A deposition source comprising consolidated Re-Y powder material, where Y is at least one non-metallic element, non-metallic compound, or ceramic material, said consolidated Re-Y powder material having greater than about 95 % of theoretical density and oxygen content below about 500 ppm, excluding oxygen from non-metallic compounds and/or ceramics.

24. The deposition source as in claim 23, wherein said consolidated Re-Y powder material has greater than about 99 % of theoretical density and oxygen content below about 200 ppm, excluding oxygen from non-metallic compounds and/or ceramics.

25. The deposition source as in claim 23, wherein Y is at least one carbide or nitride or oxide of Ti, Si, and Mg.

26. A deposition source comprising consolidated Re-X-Y powder material, where X is at least one transition metal element and Y is at least one non-metallic element, non-metallic compound, or ceramic material, said consolidated Re-X-Y powder material having greater than about 95 % of theoretical density and oxygen content below about 500 ppm, excluding oxygen from non-metallic compounds and/or ceramics.

27. The deposition source as in claim 26, wherein said consolidated Re-X-Y powder material has greater than about 99 % of theoretical density and oxygen content below about 200 ppm, excluding oxygen from non-metallic compounds and/or ceramics.

28. The deposition source as in claim 26, wherein said at least one transition metal element X is selected from the group consisting of Mo, Co, Ru, W, and Cr; and Y is at least one carbide or nitride or an oxide of Ti, Si, or Mg.
